# EUROPEAN PATENT APPLICATION

(11) **EP 1 424 779 A1**
(43) Date of publication of application: **02.06.2004**
(21) Application number: 03256973.3
(22) Date of filing: 04.11.2003
(51) Int. Cl.: H03M 7/30, H04L 29/06

(54) **Selective compression of web-based data transmissions**

(30) Priority: 26.11.2002 US 305220
(71) Applicant: BMC Software, Inc., Houston, Texas 77042-2827 (US)
(72) Inventor: Ernst, Theodore R., Sugarland Texas 77479 (US); Dugi, Greg, Richmond Texas 77469 (US)
(74) Representative: Kensett, John Hinton

(57) **Abstract**

Server-side techniques to selectively compress data for transmission to a client application are described. Characteristics such as the effective transmission rate between the server computer system and a client computer system requesting the data are used to determine if data compression is beneficial. In addition, characteristics of the server computer system such as its processor utilization, for example, may be used to determine if data compression is beneficial. Selective compression in accordance with these techniques provide improved user-responsiveness without the need to install, configure or maintain a client-side application. Accordingly, selective compression in accordance with the invention is particularly beneficial in large, distributed networks in which one or a few "server" computers provide data access service to a large number of "client" computer systems.

## Description

### Background

The invention relates generally to data compression and, more particularly but not by way of limitation, to the selective compression of data based on user-specified controls in an web-based operating environment.

Today, a significant portion of many businesses interact with the public is by way of the Internet in the form of World Wide Web browsing. In addition, most businesses have web servers with content targeted at their own employees, often referred to as "intranets." The same is true of educational institutions and government agencies. The popularity and growth of browsing the Internet and intranets have led to performance issues and user frustration with timeouts or long wait times to receive the information requested via their browsers.

Virtually all Internet and intranet traffic is carried via the Transport Control Protocol/Internet Protocol (TCP/IP). TCP/IP performance is generally excellent over lightly loaded networks (30% or lower utilization). On heavily loaded networks running at higher utilization levels (50% and above), however, serious performance bottlenecks can occur. In high utilization environments network devices such as bridges, switches and routers (which generally have very limited buffering and queuing capabilities) respond to congestion by discarding those frames or packets they cannot process. In response, the host systems that initiated transmission of the discarded frames or packets retransmit the lost data, thus adding to the congestion. It is not all that unusual to see a TCP/IP network running at 80% to 90% utilization while only experiencing 10% to 15% throughput. As a result, users experience slow response time, application faults and server disconnects. This is particularly the case for web browsers using the HyperText Transfer Protocol (HTTP). Thus, it is no surprise that administrators of heavily utilized networks have been implementing various approaches to reduce traffic and improve the performance of communications running over them.

One approach to addressing network congestion has been the development of hardware/firmware devices such as load balancers and traffic shapers - devices that attempt to regulate network loads and traffic patterns. Another approach to addressing network congestion has been to provide users with increased bandwidth in the form of faster backbones. In the intranet environment, this has meant the deployment of high-speed corporate backbones. In the Internet environment, this has meant the deployment of larger bandwidth public accessible backbones and digital subscriber lines (DSL) and cable modems for consumer use. Yet another approach to addressing network congestion is to compress data before it is transmitted. For example, a host computer system's web server may be configured to compress all of the data it transmits via a given protocol (e.g., the HTTP protocol) or to an identified destination. Web server applications that support data compression in this way include the Internet Information Services (IIS) from the Microsoft corporation, the iPlanet web server supported by Sun Microsystems and the Apache web server available through the open-source software project and supported by the Apache Software Foundation. Most currently available web servers support "gzip" compression (a compression routine freely available through the GNU Project), while all known web browsers currently available support gzip decompression.

There are at least two drawbacks to the compression techniques available in current web servers. First, the act of compressing data is processor-intensive. Second, compressing data often does not result in a significant improvement in transmission speed because the data object simply does not compress or the amount of compression achieved does not justify the computational overhead incurred by the act of compressing. For example, compressing image files such as Graphic Image Format (GIF) or Joint Photographic Experts Group (JPEG) files does not generally result in any significant reduction in the image files' size -- thus, the time spent "compressing" these types of files is wasted in the sense of improved transmission time to a web browser end-user.

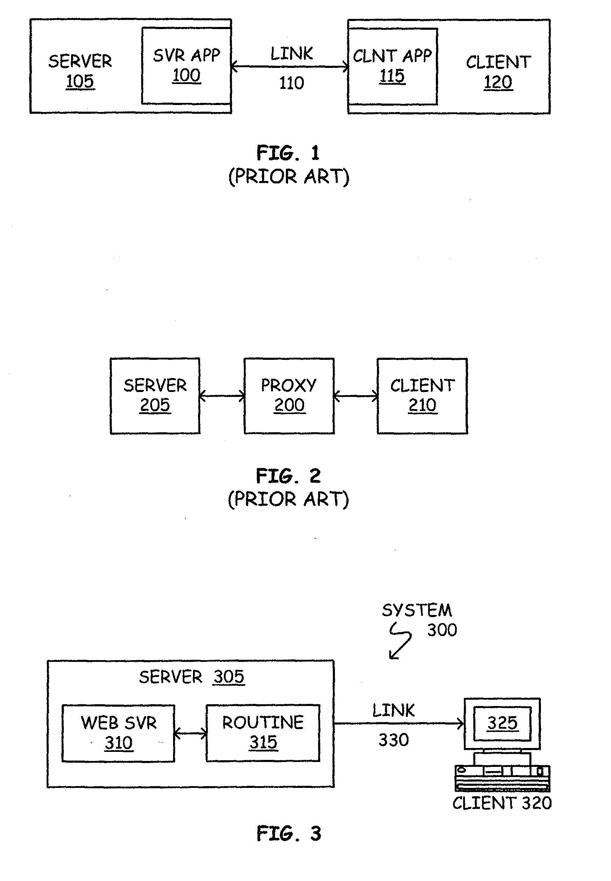

One prior art technique that recognized the drawback to an "all or nothing" compression approach is the PATROL IP/Optimizer product from BMC Software, Inc. Referring to FIG. 1, PATROL IP/Optimizer utilized a two-sided approach wherein server application **100** running on server computer system **105,** communicated via link **110** with client application **115** running on client computer system **120.** All communications of a specified type (e.g., communications related to a specified application or IP traffic) between server **105** and client **120** passed through applications **100** and **115** and could, therefore, be selectively compressed based on user specified criteria. For example, all data except specified file types (e.g., image files or files stored in compressed format) could be compressed. Another feature of IP/Optimizer's two-sided approach was that both server application **100** and client application **115** could time-stamp the packets/frames they transmitted via link **110**. This, in turn, allowed IP/Optimizer to determine the speed of link **110.** If it was determined during data packet/frame transmission between server **105** and client **120** that compression was not saving transmission time, the remainder of the data packets/frames that would have been compressed (in accordance with user specified criteria) were sent uncompressed. While a two-sided approach to selective data compression allows a large degree of control by the user, it does not scale to large networks such as the Internet (or even large corporate intranets) because it is not always practical to load client application **115** on each new client computer system. This is particularly true in the Internet environment where the "user" is a consumer.

Another prior art technique that has been used to selectively compress data between two computer systems employs a proxy server. Referring to FIG. 2, in this approach proxy server computer system **200** is inserted between web server computer system **205** and client computer system **210** in a manner that is transparent to a user of client **210.** That is, a user directs their communication to server **205** without knowledge that proxy server **200** is in place. This approach allows proxy server **200** to selectively compress data flowing from server **205** to client **210** in a manner similar to that of a system in accordance with FIG. 1. One drawback to this approach is that the purchase, installation and maintenance of proxy server **200** represents a significant cost. Another drawback to a system in accordance with FIG. 1 is that proxy server **200** represents a single point failure. That is, if proxy server **200** fails (due to hardware and/or software malfunctions) server **205** goes off-line with respect to client **210.**

Thus, it would be beneficial to provide a means to selectively compress data based on user-specified constraints in a manner that optimizes transmission of the data between two computer systems and which does not rely on client-side software and/or proxy server hardware.

### Summary

In one embodiment the invention provides a method to selectively compress data transmitted between server and client computer systems. The method includes receiving a request for data from a web-based application executing on the client computer, determining a plurality of characteristics associated with the client, passing the request to an application executing on the server, receiving a response from the server (the response having a data component), selectively compressing the data component based on a match between at least one of the client characteristics and at least one attribute associated with the data component, and transmitting the selectively compressed data component to the client. The method may be stored in any media that is readable and executable by a computer system.

According to the present invention, there is provided a method executing on a server computer to selectively compress data, comprising: receiving a request for data from a web-based application executing on a client computer, the client being different from the server; determining a plurality of characteristics associated with the client; passing the request to an application executing on the server; receiving a response from the server, the response having a data component, the data component having attributes; selectively compressing the data component based on a match between at least one of the client characteristics and at least one of the data component attributes; and transmitting the selectively compressed data component to the client.

The act of receiving a request for data may comprise receiving a request for data from an application using a web-based communication protocol.

The web-based communication protocol may be a HyperText Transport Protocol (HTTP).

The act of receiving a request in the HyperText Transport Protocol may comprise receiving a request for data from a web-browser application executing on the client.

The act of receiving a request for data may comprise receiving a request for data from an application-server application.

Preferably, the act of determining a plurality of characteristics associated with the web-based application comprises determining an Internet address associated with the client, a Uniform Resource Locator associated with the data and whether the web-based application can uncompress data.

The act of passing the request to an application may comprise passing the request to a web-server application.

The act of receiving a response from the server may further comprise identifying one or more data component attributes selected from the group consisting of size and data type.

The act of selectively compressing the data component may comprise any of;
compressing the data component if an Internet address associated with the client is an unrestricted Internet address;
compressing the data component if the data component is associated with an unrestricted Uniform Resource Locator;
compressing the data component if a processor designated to compress the data component has a utilization factor below a specified threshold;
compressing the data component if a size attribute of the data component indicates the data component is larger than a minimum specified size; or
compressing the data component if a client characteristic indicates the web-based application is capable of decompressing data.

The act of transmitting the selectively compressed data component to the client may comprise: compressing the data component in accordance with a compression routine acceptable to the web-based application; and transmitting the compressed data component to the web-based application.

A method according to the invention may further comprise recording compression information associated with the data component in a first storage.

The act of recording compression information in the first storage may comprise:
recording a uniform resource locator (URL) associated with the data component; recording a value indicative of a size of the compressed data component; and recording a value indicative of the time required to compress the data component.

The method may then comprise: storing the compressed data component in a second storage; and recording, in the first storage, an value indicative of a location of the compressed data component in the second storage.

The act of storing the compressed data component in the second storage may comprise: determining if the second storage has sufficient room to store the compressed data component; and if it does not, removing a previously stored compressed data component from the second storage, modifying a value in the first storage indicative of the location of the previously compressed data component to indicate the previously compressed data component has been removed from the second storage, and storing the compressed data component in the second storage.

The act of determining a plurality of characteristics associated with the client may comprise determining a transmission rate between the server and client.

The act of selectively compressing the data component may comprise determining whether the data component has been previously compressed and, if it has: determining a first time indicative of the time required to compress the data component; determining a second time indicative of the time required transmit the compressed data component; determining a third time indicative of the time required to transmit the data component; and compressing the data component if the sum of the first time and the second time is less than the third time by at least a specified amount.

In preferred embodiments, the specified amount may be zero (0) or may be greater than zero.

The act of selectively compressing the data component and transmitting the selectively compressed data component to the client may comprise determining whether the data component has been previously compressed and, if it has, whether it is available and, if it is, then transmitting the previously compressed data component to the client.

The invention further provides a program storage device, or a data carrier, readable by a programmable control device, comprising instructions stored on the program storage device or data carrier for causing a server computer to: receive a request for data from a web-based application executing on a client computer, the client computer being different from the server computer; determine a plurality of characteristics associated with the client; pass the request to an application executing on the server; receive a response from the server, the response having a data component, the data component having attributes; selectively compress the data component based on a match between at least one of the client characteristics and at least one of the data component attributes; and transmit the selectively compressed data component to the client.

The instructions to receive a request for data from a web-based application may comprise instructions to receive a request for data from an application using a HyperText Transport Protocol (HTTP).

The instructions to determine a plurality of characteristics associated with the web-based application may comprise instructions to determine an Internet address associated with the client and a Uniform Resource Locator associated with the data.

The instructions to receive a response from the server may comprise instructions to identify a size attribute of the data component.

The instructions to selectively compress the data component, may comprise any of:
instructions to compress the data component if the client computer is associated with an unrestricted Internet address;
instructions to compress the data component if the data is associated with an unrestricted Uniform Resource Locator; or
instructions to compress the data component if a processor designated to compress the data component has a utilization factor below a specified threshold.

The instructions to transmit the selectively compressed data component to the client may comprise instructions to record compression information associated with the data component in a first storage.

The instructions to determine a plurality of characteristics associated with the client may comprise instructions to determine a transmission rate between the server and client.

The instructions to selectively compress the data component may comprise instructions to determine whether the data component has been previously compressed and, if it has: determine a first time indicative of the time required to compress the data component; determine a second time indicative of the time required transmit the compressed data component; determine a third time indicative of the time required to transmit the data component; and compress the data component if the sum of the first time and the second time is less than the third time by at least a specified amount.

Preferably, the instructions to compress the data component may be performed if the specified amount is zero (0), or is greater than zero.

According to the present invention in a further aspect, there is provided a method to selectively compress data, comprising: receiving, at a server computer system, a request for data from a client computer system, the client computer system being different from the server computer system; determining a uniform resource locator (URL) associated with the requested data and a transmission rate between the server and client computer systems; passing the request for data to a web-server application executing on the server computer system; receiving a response from the web-server application, the response having a data component, the data component having a size; determining if the data component has previously been compressed and, if it has, further determining if the compressed data component is available and, if it is, transmitting the compressed data component to the client, else, determining a first time indicative of the time required to compress the data component, a second time indicative of the time required to transmit the compressed data component to the client, a third time indicative of the time required to transmit the data component to the client, and compressing the data component if the sum of the first time and the second time is less than the third time by at least a specified amount and transmitting the compressed data component to the client; else selectively compressing the data component if the URL associated with the data is an unrestricted URL; and transmitting the selectively compressed data component to the client computer system.

Preferably, the act of selectively compressing the data component further comprises compressing the data component if an Internet address associated with the client computer system is an unrestricted Internet address.

The act of selectively compressing the data component may further comprise compressing the data component if the data component has a size larger than a minimum specified value.

The act of selectively compressing the data component may further comprise compressing the data component if a processor designated to for compress the data component has a utilization factor below a specified maximum value.

### Brief Description of the Drawings

Figure 1 shows a block diagram of one prior art system used to selectively compress data between server and client computer systems.
Figure 2 shows a block diagram of another prior art system that can be used to selectively compress data between server and client computer systems.
Figure 3 shows a block diagram of a computer system in accordance with one embodiment of the invention.
Figure 4 shows, in flowchart form, a selective compression routine in accordance with one embodiment of the invention.
Figure 5 shows, in time sequence, how a selective compression routine captures client information during HyperText Transport Protocol (HTTP) connection set-up in one embodiment of the invention.
Figure 6 shows, in flowchart form, how a selective compression routine in accordance with one embodiment of the invention determines if the data it receives is eligible for compression.
Figure 7 shows, in block diagram form, data storage areas used and maintained by a selective compression routine in accordance with one embodiment of the invention.
Figure 8 shows, in flowchart form, how a selective compression routine in accordance with one embodiment of the invention determines if the data it receives has previously been compressed and, if so, if the compressed data is available for transmission.
Figure 9 shows, in flowchart form, the acts of block **440** in FIG. 4 in accordance with one embodiment of the invention.

### Detailed Description

The invention relates generally to data compression and more particularly to server-side only techniques for the selective compression of data based on user-specified controls in an web-based operating environment. As used herein, the phrase "server-side only" refers to techniques that rely on the execution of routines on a server computer system and, in particular, do not rely on or require the installation and operation of special purpose software or hardware on a client computer system specifically designed to operate with those routines.

Referring to FIG. 3, system **300** in accordance with one embodiment of the invention comprises server computer system **305** on which web server application **310** and selective compression routine **315** execute. As shown, routine **315** is logically positioned between web server application **310** and client computer system **320** executing conventional web browser application **325.** Accordingly, data requests from browser **325** are received and passed to web server **310** by routine **315.** Similarly, data returned by web server **310** in response to such requests are first received by routine **315** before being sent to browser **325** (with or without modification as described herein). It will be recognized that communication link **330** may be a dedicated point-to-point connection, a local or wide area network such as an intranet or the Internet and that any of these "communication links" may employ wired or wireless technology. While the following descriptions of routine **315** assume client-server communications via the HyperText Transport Protocol (HTTP), such descriptions are illustrative only and are not to be considered limiting in any respect.

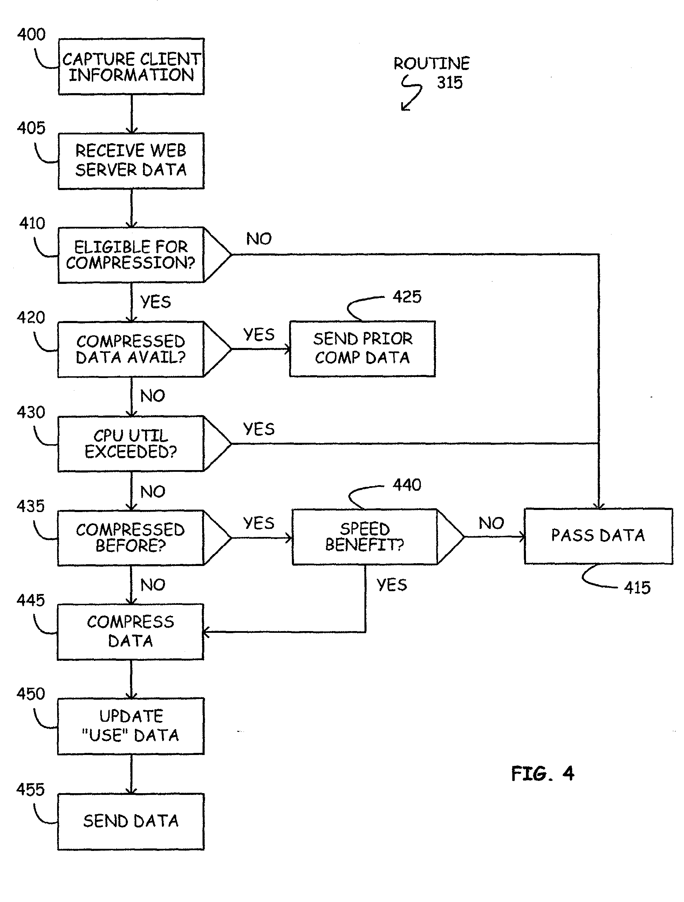

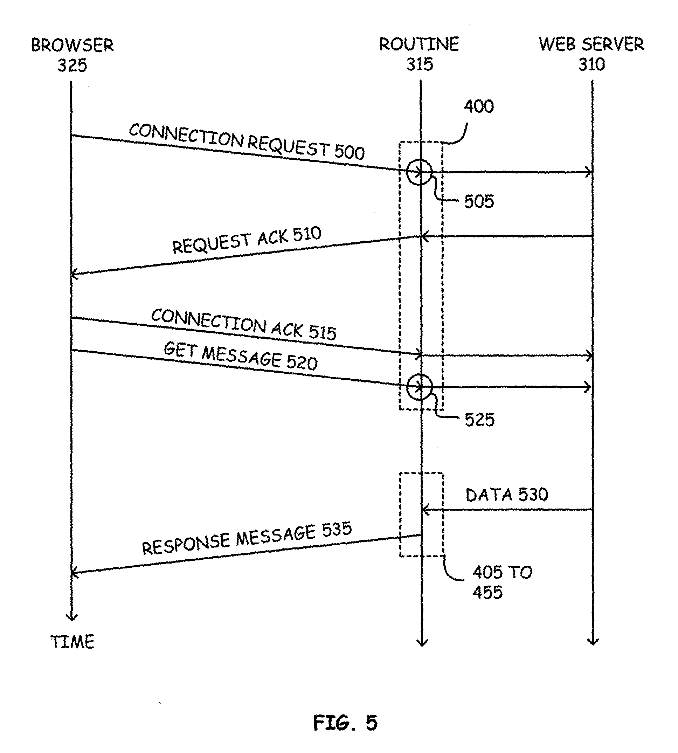

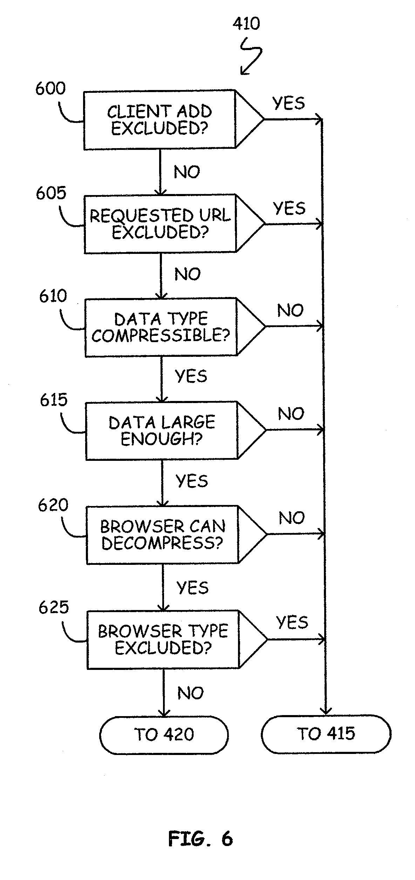

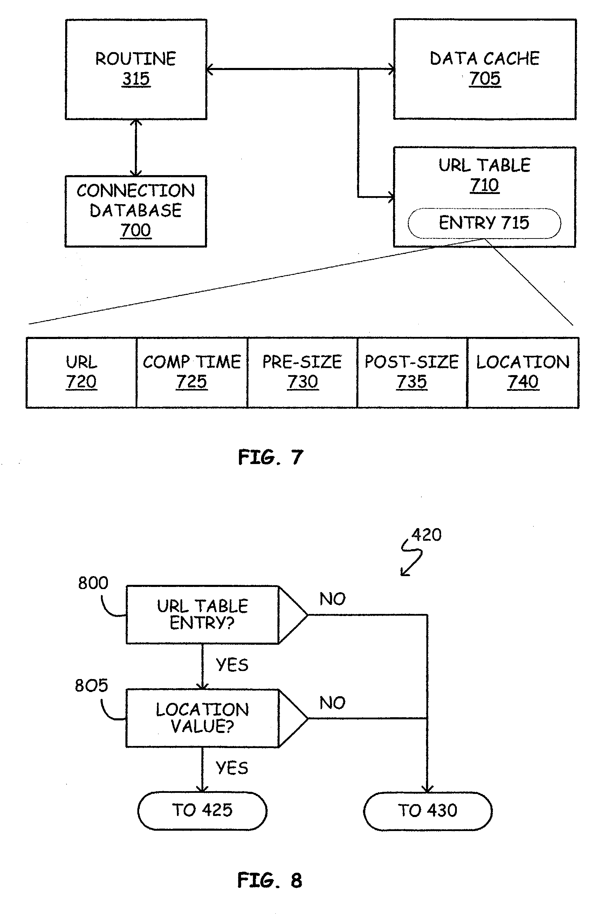

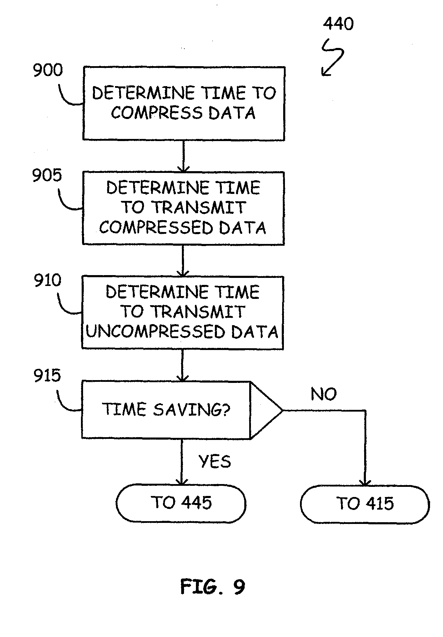

Referring to FIG. 4, routine **315** in accordance with one embodiment of the invention begins by determining certain client **320**/browser **325** information (block **400**). (See discussion below regarding FIG. 5.) For example, routine **315** may determine the approximate data transfer rate between browser **325** and web server **310** during connection set-up operations. In addition, routine **315** may ascertain if browser **325** supports decompression utilities. When routine **315** receives web server **310'**s response to browser **325'**s request for data (block **405**), it determines whether the data contained therein is eligible for compression (decision block **410**). (See discussion below regarding FIG. 6.) By way of example, data less than a specified size, or data already in a compressed format, or of a specified file type, or requested from one or more specified locations (e.g., URL patterns, see discussion below), or directed to one or more specified Internet addresses or data requested by a specified browser application (e.g., the Netscape browser of a specified version) may be designated "not eligible." If the data is not eligible for compression (the "NO" prong of decision block **410**), the data received from web server **310** during the acts of block **405** is passed or relayed to browser **325** without further processing (block **415**). If the data is eligible for compression (the "YES" prong of decision block **410**), routine **315** next determines if it has previously compressed the data and, if so, if the compressed data is available for transmission to browser **325** (decision block **420**). (See discussion below regarding FIG. 7.) In one embodiment, routine **315** retains knowledge about, for example, whether it has previously compressed a specified data object, and, if so, the amount of compression achieved, the amount of time it took to perform the compression and whether that compressed data object is currently available for transmission to browser **325**. If previously compressed data is available (the "YES" prong of decision block **420**), the compressed data is sent to browser **325** (block **425**). In one embodiment, if previously compressed data is not available (the "NO" prong of decision block **420**), a further check is made to determine if the central processor unit executing routine **315** and/or designated to compress data for routine **315** is below a specified utilization (decision block **430).** The check of block **430** may be performed to ensure that server **305** (or a functional unit associated with server **305)** is not tasked to perform a computationally intensive job (the act of compressing data) if it is already heavily utilized for other tasks. For example, a utilization threshold may be set at a specified percentage of the processor's total capacity. In some embodiments, this threshold may be set at the user's discretion anywhere from 0% to 100%. For example 85%. If routine **315'**s processor's utilization is at or above the specified threshold (the "YES" prong of decision block **430),** data received from web server **310** during the acts of block **405** is passed or relayed to browser **325** without further processing (block **415).** If routine **315'**s processor's utilization is below the specified threshold (the "NO" prong of decision block **430**), routine **315** determines if it has previously compressed the data (decision block **435**). (See discussion below regarding FIGS. 7 and 8.) If routine **315** has previously compressed the data and that compressed data is currently not available (the "YES" prong of decision block **435**), it then determines if compressing the data would provide a transmission benefit (block **440**). (See discussion below regarding FIG. 9.) For example, based on the determined transmission rate between web server **310** and browser **325** (in accordance with the acts of block **400**) and the amount of time it takes to compress the data object, routine **315** can determine if the time it will take to compress the data object provides an acceptable speed-up in transmission (decision block **440**). In one embodiment, if the time saved in transmitting the compressed data does not save more time (at the determined transmission rate between web server **310** and browser **325**) than it takes to compress the data (the "NO" prong of decision block **440**), the data received from web server **310** during the acts of block **405** is passed or relayed to browser **325** without further processing (block **415).** In another embodiment, if the time saved in transmitting the compressed data does not save at least a specified amount of time, above the time it takes to compress the data (e.g., 110%), the data received from web server **310** during the acts of block **405** is passed or relayed to browser **325** without further processing (block **415**). If routine **315** determines that the time saved in transmitting the compressed data is acceptable/beneficial (the "YES" prong of decision block **440**) or if the data received from web server **310** has not yet been compressed (the "NO" prong of decision block **435**), routine **315** compresses the data (block **445**). While routine **315** may use any compression routine/technique, for historical reasons most current browsers (e.g., browser **325**) incorporate the ability to decompress data in gzip format. After compressing the data, routine **315** may update a metadata store it uses to track what data objects its has compressed (block **450**) and then transmit the compressed data to browser **325** (block **455**). (See discussion below regarding FIGS. 7 and 8.)

Figure 5 illustrates how one embodiment of routine **315** begins the capture of client information (see block **400** in FIG. 4) during establishment of an HTTP connection between browser **325** and web server **310**. As shown, HTTP connection setup is initiated when browser **325** transmits Connection Request message **500** to web server **310** via routine **315.** On receipt of Connection Request **500,** routine **315** initiates a timer **(505).** Web server **310** responds to Connection Request message **500** by issuing Request Acknowledgement message **510.** Browser **325**, in turn, responds by issuing Connection Acknowledgement message **515**. At this point, an HTTP connection between browser **325** and web server **310** is established. Substantially immediately after issuing Connection Acknowledgement message **515**, browser **325** issues Get message **520** to initiate transfer of the data for which the connection was established. On receipt of Get message **520**, routine **315** stops the timer **(525).** The interval measured by the timer approximates the roundtrip time between browser **325** and web server **310** and may be used to determine a transfer rate (i.e., bytes/second) because routine **315** also has knowledge of the size of each of Connection Request **500**, Request Acknowledgement **510**, Connection Acknowledgement **515** and Get **520** messages. One of ordinary skill in the art will recognize that the transmission rate between browser **325** and web server **310** could more accurately be determined by stopping the timer on receipt of Connection Acknowledgement message **515.** In practice, however, it has been found that the time difference between receiving browser **325'**s Connection Acknowledgement **515** and Get **520** messages is so small that it does not significantly affect the determination of the transmission rate. In addition to determining the transfer rate between browser **325** and web server **310**, routine **315** may also capture certain additional client **320**/browser **325** information **( 525).** For example, the Internet (IP) address associated with client **320** may be captured at the time Connection Request message **500** is received. In addition, HTTP Get message **520** can be used to identify: (1) the data being sought in terms of its URL; (2) the highest HTTP level supported by browser **325**; (3) browser **325** type; (4) what file types browser **325** can accommodate; (5) whether browser **325** supports decompression via, for example, gzip or tar utilities; and (6) other capabilities such as, for example, platform configuration and software version information.

Figure 6 illustrates how one embodiment of routine **315** determines if data **530** (see FIG. 5) received from web server **310** is eligible for compression (see block **410** in FIG. 4). As shown, an initial check is made to determine if the IP address associated with client **320** has been excluded by the user (decision block **600**). For example, the user may not want to compress any data transmitted to IP address AAA.1.1.1 or the block of IP addresses identified by 1B.*.*.* (i.e., all IP addresses beginning with 1B). If client **320**'s IP address has been excluded or restricted as described above (the "YES" prong of decision block **600**), control passes to block **415** in FIG. 4. If client **320**'s IP address has not been excluded or is unrestricted (the "NO" prong of decision block **600**), a second check is made to determine if data **530** is from a specified one or more locations (decision block **605**). That is, the invention allows the user to identify one or more restricted URLs. For example, a user may not want to compress data requested from the location identified by the URL http://www.bmc.com/abc or from any destinations identified via the URL pattern http://www.bmc.com/* (meaning any destination at the bmc.com web site). If data **530**'s URL has been excluded or restricted as described above (the "YES" prong of decision block **605**), control passes to block **415** in FIG. 4. If data 530's URL has not been excluded (the "NO" prong of decision block **605**), a third check is made to determine if data **530** is compressible (decision block **610).** For example, image files such as Graphic Image Format (GIF) and Joint Photographic Experts Group (JPEG) files are not typically compressible and are, therefore, not generally processed further. In addition, archive files such as "zip" and "tar" files are already in compressed form and are, therefore, not generally processed further. Further, a user may specify that certain file types (e.g., Portable Document Format, PDF, files) are not to be compressed. If data **530** is not compressible (the "NO" prong of decision block **610**), control passes to block **415** in FIG. 4. If data **530** in compressible (the "YES" prong of decision block **610**), a fourth check is made to determine if data **530** is at least a minimum size (decision block **615**). This test is performed to avoid compressing files that are so small that the computational overhead of compressing them exceeds the time savings obtained in their transmission. An illustrative "minimum size" is 200 bytes. If the size of data **530** is less than or equal to a minimum specified size (the "NO" prong of decision block **615**), control passes to block **415** in FIG. 4. If data **530** in larger than the minimum specified size (the "YES" prong of decision block **615**), a fifth check is made to determine if browser **325** is capable of handling compressed data (decision block **620**). If browser **325** cannot handle compressed data (the "NO" prong of decision block **620**), control passes to block **415** in FIG. 4. If browser **325** can handle compressed data (the "YES" prong of decision block **620**), a sixth check is made to determine if the user has restricted compressed transmission to the specific type of browser making the request (decision block **625**). For example, a user may specify that compressed data is not to be sent to version 6 of browsers provided by the Netscape Corporation. If browser **325** is a type (i.e., has a "signature") that has been excluded by the user (the "YES" prong of decision block **625),** control passes to block **415** in FIG. 4. If browser **325** is of a type not excluded by the user (the "NO" prong of decision block **625),** control passes to decision block **420** in FIG. 4. One of ordinary skill in the art will recognize that one or more additional tests may also be implemented or that fewer than the described tests can be performed or that the tests may be run in various orders. For example, if certain browser types are known to be unable to handle certain data in compressed form (even if they can handle compressed data in general), a test may be performed for this/these conditions.

Referring now to FIG. 7, in one embodiment of the invention routine **315** maintains, and has access to, three (3) storage areas: connection database **700,** data cache **705** and URL table **710** (see, for example, the discussion above regarding FIG. 4 at blocks **420** and **435- 450**). Connection database **700** is used by routine **315** to track each user request for data (i.e., an HTTP connection in accordance with **500, 510, 515** and **520** of FIG. 5). For example, unique identifiers may be assigned to each requesting agent (e.g., browser **325** in FIG. 3). In addition, this storage is where routine **315** typically records the transmission rate determined in accordance with block **400** in FIG. 4 and discussed above regarding FIG. 5. Data cache **705** is used by routine **315** to store data received from web server **310** that has been compressed. URL table **710** is used to store metadata associated with each compressed data object and, in one embodiment, is organized in accordance with the data object's URL value. In the embodiment of FIG. 7, each URL table entry **715** identifies a data object's URL **720**, the time it took to compress the data object **725**, the data object's size before compression **730**, the data object's size after compression **735** and the location of the compressed data object **740** in data cache **705**. In one embodiment, each data object that has been compressed is stored in data cache **705** and each compressed object has an entry in URL table **710.** In another embodiment, data cache **705** may be smaller than needed to store all compressed data objects and/or URL table **710** may be smaller than needed to store all of the compressed data object's metadata entries. In the latter case, it may be necessary to periodically remove some entries from data cache **705** and/or URL table **710** to make room for a new entry. Techniques to do this are known in the art as cache management techniques. One of ordinary skill in the art will recognize that a consequence of limited storage can be that URL table **710** may contain an entry for a data object that has been removed (flushed) from data cache **705**. Accordingly, when a data object is removed from data cache **705**, its entry in URL table **710** is either removed or, in a preferred embodiment, modified to note this. For example, the "removed" object's URL table's entry may have its location field **740** set to a value indicating that the object no longer is available. In this latter embodiment, URL table entries corresponding to data objects that have been removed from data cache **705**, may be beneficial during the acts of blocks **420, 435** and **440** of FIG. 4.

In one embodiment of the invention, routine **315** makes use of the storage structures of FIG. 7 to determine if a compressed data object is available for transmission (block **420** in FIG. 4), whether the data object being processed has been previously compressed (block **435** in FIG. 4) and whether compressing the data object will provide a benefit (block **440** in FIG. 4). Referring to FIG. 8, the acts of block **420** to determine if a compressed data object is available comprise determining if the data object has a URL table entry (decision block **800**). If the data object does not have a URL table entry (the "NO" prong of decision block **800**), either the data object has never been compressed before or, if it has, both its data cache and URL table entries have been purged (see discussion above). In either case, control is passed to block **430** in FIG. 4. If the data object has a URL table entry (the "YES" prong of decision block **800**), a check is made to determine if the URL table entry has an associated data cache entry (decision block **805**). If the data object's URL table entry (i.e., its location field **740**) does not identify a compressed object in data cache **705** (the "NO" prong of decision block **805**), control is passed to block **430** in FIG. 4. If, on the other hand, the data object's URL table identifies an entry in data cache **705** (the "YES" prong of decision block **805**), control passes to block **425** in FIG. 4. Similarly, the acts of block **435** to determine if the data object being processed has been previously compressed, routine **315** determines if the data object has a URL table entry. Referring now to FIG. 9, the acts of block **440** to determine if there would be a speed benefit to compressing the current data objects comprise determining the time it would take to compress the data object (block **900**). For example, the data object's URL table entry's compression time field **725** provides this information. Next, the time needed to transmit the compressed data object based on the transmission rate calculated in accordance with block **400** of FIG. 4 and recorded in connection database **700** is determined (block **905**). A similar calculation is performed to determine the time needed to transmit the uncompressed data object (block **910).** If the calculated time savings meets or exceeds a specified level as discussed above (the "YES" prong of decision block **915**), control is passed to block **445** in FIG. 4. If the calculated time savings does not meet the specified level (the "NO" prong of decision block **915**), control is passed to block **415** in FIG. 4. It is noted, that the acts of block **440** (and FIG. 9) are only performed if the data object being processed has a corresponding URL table entry but no data cache entry.

In some embodiments, if the data being transmitted from web server **310** to browser **325** (e.g., data **530** of FIG. 5) was dynamically generated, it is not stored in data cache **705** and an entry for the data object is not stored in URL table **710**. That is, the acts of block **450** (see FIG. 4) are not performed for dynamically generated data objects. In the context of the current discussion, the phrase "dynamically generated" refers to data (e.g., data **530**) whose content is uniquely generated by the responding application (e.g., web server **310**) in answer to a user query (e.g., Get message **520**) and which may change from query to query. For example, data **530** may comprise a dynamically generated HyperText Markup Language (HTML) web-page.

One benefit of a compression routine in accordance with the invention is that only server-side installation and execution is required. This can provide significant advantage over techniques and technologies that require and rely on the operation of companion software and/or hardware on client side computer systems. This advantage is particularly relevant in distributed environments such as the Internet in which a provider organization (e.g., a business operating computer server **305** in FIG. 3) provides services and/or data to an unknown number of users via standard Internet messaging protocols. Another benefit of a compression routine in accordance with the invention is that only data that a user (e.g., the operator of computer server **305**) determines to be beneficial is compressed. Yet another benefit of a compression routine in accordance with the invention is that characteristics other than the data itself may be considered to determine if it is beneficial or desirable to compress data. For example, the IP address of the destination computer server may be considered as can the inherent capabilities of the receiving application (e.g., a web browser). It has been found that selective compression in accordance with the techniques described herein, provide a twenty percent (20%) to fifty percent (50%) improvement in transmission speed to client applications in a web-based environment.

Various changes in the materials, components, circuit elements, as well as in the details of the illustrated operational methods are possible without departing from the scope of the claims. For instance, computer server **305** in FIG. 3 may be a mainframe computer system, a high-performance workstation computer system, a personal computer system or a specially designed device to interact with web-based communications (e.g., via link **330**). Furthermore, any of these embodiments may execute any desired operating system. In addition, acts in accordance with FIGS. 4, 5, 6, 8 and 9 may be performed by a programmable control device executing instructions organized into a program module (e.g., routine **315**). A programmable control device may be a single computer processor, a plurality of computer processors coupled by a communications link, or a custom designed state machine. Custom designed state machines may be embodied in a hardware device such as a printed circuit board comprising discrete logic, integrated circuits, or specially designed application specific integrated circuits (ASICs). Storage devices suitable for tangibly embodying program instructions include all forms of non-volatile memory including, but not limited to: semiconductor memory devices such as electrically programmable read only memory (EPROM), electrically erasable programmable read only memory ( EEPROM), and flash devices; magnetic disks (fixed, floppy, and removable); other magnetic media such as tape; and optical media such as CD-ROM disks. Similarly, one of ordinary skill in the art will recognize that connection database **700,** data cache **705** and URL table **710** (see FIG. 7) may be embodied in one or more physical storage devices such as, for example, dynamic and static random access memory (DRAM and SRAM) devices. It will further be recognized that the size of each of connection database **700,** data cache **705** and URL table **710** is an implementation detail, but that the sizes chosen will impact the number of entries that may be retained in each and, as a consequence, the need or desirability of various memory management techniques.

While the invention has been disclosed with respect to a limited number of embodiments, numerous modifications and variations will be appreciated by those skilled in the art. It is intended, therefore, that the following claims cover all such modifications and variations that may fall within the true sprit and scope of the invention.

## Claims

1. A method executing on a server computer to selectively compress data, comprising:
receiving a request for data from a web-based application executing on a client computer, the client being different from the server;
determining a plurality of characteristics associated with the client;
passing the request to an application executing on the server;
receiving a response from the server, the response having a data component, the data component having attributes;
selectively compressing the data component based on a match between at least one of the client characteristics and at least one of the data component attributes; and
transmitting the selectively compressed data component to the client.

2. The method of Claim 1, wherein the act of receiving a request for data, comprises receiving a request for data from an application using a web-based communication protocol.

3. The method of Claim 1 or 2, wherein the act of passing the request to an application comprises passing the request to a web-server application.

4. The method of any preceding claim, wherein the act of receiving a response from the server further comprises identifying one or more data component attributes selected from the group consisting of size and data type.

5. The method of any preceding claim, wherein the act of selectively compressing the data component comprises, compressing the data component if an Internet address associated with the client is an unrestricted Internet address.

6. The method of any of Claims 1 to 4, wherein the act of selectively compressing the data component comprises, compressing the data component if the data component is associated with an unrestricted Uniform Resource Locator.

7. The method of any of Claims 1 to 4, wherein the act of selectively compressing the data component comprises, compressing the data component if a processor designated to compress the data component has a utilization factor below a specified threshold.

8. The method of any of Claims 1 to 4, wherein the act of selectively compressing the data component comprises, compressing the data component if a size attribute of the data component indicates the data component is larger than a minimum specified size.

9. The method of any preceding claim, wherein the act of transmitting the selectively compressed data component to the client comprises:
compressing the data component in accordance with a compression routine acceptable to the web-based application; and
transmitting the compressed data component to the web-based application.

10. A data carrier, readable by a programmable control device, comprising instructions stored on the data carrier for causing a server computer to:
receive a request for data from a web-based application executing on a client computer, the client computer being different from the server computer;
determine a plurality of characteristics associated with the client;
pass the request to an application executing on the server;
receive a response from the server, the response having a data component, the data component having attributes;
selectively compress the data component based on a match between at least one of the client characteristics and at least one of the data component attributes; and
transmit the selectively compressed data component to the client.
